(19) Europäisches Patentamt
European Patent Office
Office européen des brevets

(11) EP 0 714 136 A1

(12) **EUROPEAN PATENT APPLICATION**

(43) Date of publication:
**29.05.1996 Bulletin 1996/22**

(51) Int. Cl.[6]: **H01L 29/165**, H01L 31/0376

(21) Application number: **95117698.1**

(22) Date of filing: **09.11.1995**

(84) Designated Contracting States:
**DE FR IT**

(30) Priority: **09.11.1994 JP 274781/94**
**27.10.1995 JP 280596/95**

(71) Applicant: **RESEARCH DEVELOPMENT CORPORATION OF JAPAN**
**Kawaguchi-shi, Saitama-ken 332 (JP)**

(72) Inventors:
- **Yu, Hongan**
  **Numazu-shi, Shizuoka, 410-03 (JP)**
- **Otani, Sugio**
  **Kiryu-shi, Gunma, 376 (JP)**
- **Kaneko, Tomohiko**
  **Numazu-shi, Shizuoka, 410-03 (JP)**

(74) Representative: **Geyer, Ulrich F., Dr. Dipl.-Phys. et al**
**WAGNER & GEYER,**
**Patentanwälte,**
**Gewürzmühlstrasse 5**
**D-80538 München (DE)**

# (54) Heterojunction type or Schottky-barrier type semiconductor element and solar cell

(57) The present invention provide a heterojunction type or Schottky-barrier type semiconductor element wherein a carbonaceous thin film is chemically vapor-deposited on an n-type or p-type semiconductor substrate and a solar cell or the like as an application thereof.

EP 0 714 136 A1

Printed by Rank Xerox (UK) Business Services
2.11.9/3.4

## Description

### FIELD OF THE INVENTION

The present invention relates to a heterojunction type or Schottky-barrier type semiconductor element and a solar cell. More particularly, the present invention relates to a novel heterojunction type or Schottky-barrier type semiconductor element comprising a carbonaceous thin film, which is applicable as an electronic device, a solar cell and so on.

### PRIOR ART AND PROBLEMS

Various semiconductor elements have so far been developed as electronic devices, optoelectric transducers and solar cells, and research efforts have actively been made to sophisticate functions thereof and to find new applications based on new properties derived from new combinations of materials.

While, among these semiconductor elements, silicon semiconductors or compound semiconductors have formed the main current, research on organic semiconductors has recently made a marked progress.

Carbonaceous materials typically represented by graphite, on the other hand, having excellent chemical, mechanical, biological and electronic properties are known to be applicable in a wide range of areas including space technology, sporting goods, and biological materials. Furthermore, the important role which may be played by carbonaceous $\pi$ electronic materials as next-generation electronic materials is now entertained, in view of such electronic properties as ultra-high speed electron mobility and ultra-polarizability of graphite.

From the point of view of physics, carbonaceous materials come under the category of semiconductor materials. In general, for example, the carbonaceous materials heat-treated at a temperature of up to 800°C shows a positive Hall constant. According as the heat-treatment temperature becomes higher, the Hall constant decreases and changes into a negative one at a temperature of over 800°C. The sign of Hall constant once changes into positive at about 1,600°C along with a further increase in temperature, and changes again into negative at 2,400°C. This property of the carbonaceous materials suggests the possibility of making an electronic device by utilizing this property.

However, practical application of graphite to electronic materials, particularly to electronic devices has not as yet been achieved to date. The main reason is that a high graphite formation temperature of over 2,500°C is required in general. As compared with monocrystalline graphite, amorphous one can be formed at a far lower temperature. Particularly, a thin (<1,000 Å) amorphous carbon thin film produced by the CVD method can have a high electric conductivity (usually within a range of from about $10^{-4}$ to $10^{3}$ S/cm) through a heat treatment at a temperature of under 1,000°C, and exhibits a light transmissivity to some extent. This suggests the possibility of application as an electronic device material, particularly, as a solar cell material.

The solar cells practically used at present mainly comprise silicon semiconductor and compound semiconductor, but not one made of organic materials. On the other hand, however, active research efforts have been made on solar cells utilizing organic thin films since invention of conductive polyacetylene in 1977. A major problem involved in current organic solar cells is that they are poor in stability and low in energy cenversion ratio.

Various findings to be noted have been reported on carbonaceous materials with increasing expectation as semiconductor materials. But studies or reports teaching achievement of more concrete and practicable semiconductor elements have not as yet been made.

In view of the circumstances as described above, therefore, the present invention has an object to provide means to permit achievement of a semiconductor element by a new approach to carbonaceous materials. More specifically, the present invention has an object to achieve an optoelectric conversion diode and a solar cell using an amorphous carbonaceous thin film as an application of carbonaceous materials to electronic devices.

### SUMMARY OF THE INVENTION

As means to solve the problems as described above, the present invention provides a heterojunction type or Schottky-barier type semiconductor element wherein a carbonaceous thin film is chemically vapor-deposited (CVD) on an n-type or p-type semiconductor substrate and a solar cell as an application thereof.

### BRIEF DESCRIPTION OF THE DRAWINGS

Figure 1 shows a perspective view illustrating the construction of a carbonaceous thin film/n-type silicon multilayer sample of the present invention.

Figure 2 shows an I-V characteristic diagram of a carbonaceous thin film/n-type silicon multilayer sample as an embodiment.

Figure 3 shows a semi-logarithmic I-V characteristic diagram of a carbonaceous thin film/n-type silicon multilayer sample as an embodiment.

Figure 4 shows a spectroscopic characteristic diagram of a carbonaceous thin film/n-type silicon multilayer sample as an embodiment.

Figure 5 shows a relational diagram illustrating an absorption spectrum of a carbonaceous thin film as an embodiment.

Figure 6 shows a schematic view illustrating the junction band structure of a 500°C carbonaceous thin film/n-type silicon multilayer sample as an embodiment.

Figure 7 shows a temperature characteristic diagram illustrating for the optical band gap Eopt of a carbonaceous thin film as an embodiment.

## DETAILED DESCRIPTION OF THE INVENTION

The present invention permits achievement of a novel semiconductor element not known so far by the use of the chemically vapor-deposited carbonaceous thin film and the n-type or p-type semiconductor substrate as described above, and allows application thereof to, for example, a diode, a rectifier element, a photodiode, an optical sensor and a solar cell.

There is no particular limitation on the kind of the semiconductor substrate which constitutes the heterojunction type semiconductor element, but any n-type or p-type semiconductor substrate may be used: monocrystalline silicon, polycrystalline silicon, amorphous silicon, or compound semiconductor, or other n-type or p-type semiconductor substrate corresponding to any one thereof, in the form of a sheet or a thin film.

The carbonaceous thin film to be chemically vapor-deposited (CVD) on such a semiconductor substrate may be formed from at least a kind of organic compound, particularly a carbocyclic organic compound as the raw material in the present invention. This carbocyclic organic compound may be selected from a wide range of kinds of compounds including hexacyclic benzene compounds and pentacyclic or septocyclic no-benzene compounds. Even a monocyclic or polycyclic organic compound including a pentacyclic or septocyclic one may be preferably employed in the present invention.

For example, as such carbocyclic organic compound, any compound selected from a quinone hexacyclic compound such as 2,5-dimethyl-p-benzoquinone of the following formula:

[Chemical formula 1]

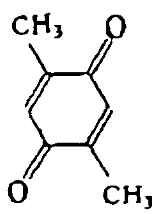

or decacyclene having a more complicated ring system of the following formula:

[Chemical formula 2]

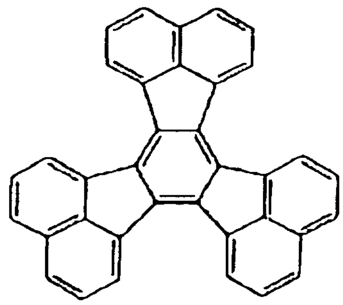

may be used.

In the present invention, apart from one or more carbocyclic compounds used as raw materials, a chain carbon compound, or as required, an organic compound containing such atoms as oxygen, nitrogen, boron, phosphorus and halogen as hetero-elements may be used as a kind of carbocyclic compound. These constituents make the carbonaceous thin film more interesting.

While chemical vapor deposition (CVD) can be applied by using any of these materials serving as the carbon source, the reaction may be caused thermally, or separately from, or in combination with excitation by a light or plasma. Most simply, a carbonaceous thin film of the present invention can be formed on said n-type or p-type semiconductor substrate by thermochemical vapor deposition. In this film formation, a material different from the carbon source material may be used as the source materials of the above-mentioned hetero-atom in the form of doping.

For the purpose of constructing the heterojunction type or Schottky-barrier type semiconductor element of the present invention, the chemically vapor-deposited carbonaceous thin film should preferably comprise at least 80% (weight percentage) carbon. With a carbon content of under 80%, it is difficult to obtain a desired element having marked or stable properties as desired. The carbonaceous thin film should mainly comprise a non-diamond structure. The structure commonly known as the diamond structure, exhibiting insulating property, is naturally named as such. In the present invention, the non-diamond structure is considered to be formed by a structure in which a conjugate system of the carbonaceous compound in the above-mentioned carbonaceous thin film sufficiently expands.

For example, in chemical vapor deposition from 2,5-dimethyl-p-benzoquinone and decacyclene described above, a carbonaceous thin film expressed in the following structural models are estimated to be formed:

[Chemical formula 3]

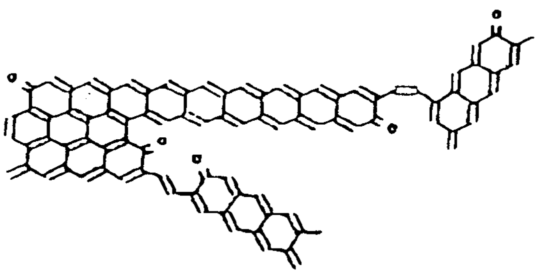

[Chemical formula 4]

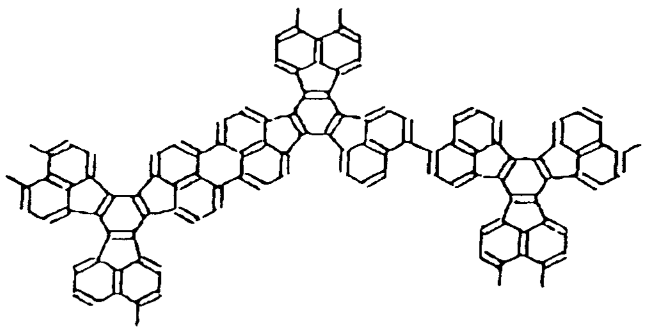

When chemical vapor deposition is thermally conducted, a preferable embodiment comprises, a carbocyclic organic compound as the raw material and a temperature up to 1000°C.

The heterojunction type or Schottky-barrier type semiconductor element provided by the present invention has specific photoelectric characteristics and is expected to be applied to a solar cell or the like.

It is needless to mention that various embodiments are possible as to the material for electrodes as semiconductor elements and their arrangement.

Now therefore, the construction and effects of the present invention will be described further in detail by means of some examples.

Example 1

An n-type silicon monocrystalline wafer with phosphorus (P) as dopant, having a thickness of 0.5 mm, was used as the substrate. Prior to depositing a carbonaceous thin film, the substrate was washed with fluoric acid in a concentration of 20%. The raw material for CVD reaction was 2,5-dimethyl-p-benzoquinone. The CVD reaction was caused under the following conditions under the atmospheric pressure:

| | |
|---|---|
| Substrate temperature: | 500°C |
| Material vaporizing temperature: | 110°C |
| Carrier gas: | argon |
| Depositing time: | 90 minutes |

The thus deposited carbonaceous thin film had a thickness of about 400 Å. In the resultant multilayer sample of carbonaceous thin film/n-type monocrystalline silicon, alloy electrodes were attached to the back of the silicon substrate by ultrasonic welding. In addition, a gold thin film having a thickness of 80 to 100 Å was vacuum-deposited on the surface of the carbonaceous thin film to form a surface electrode. The structure of the thus prepared cell sample is illustrated in Fig. 1.

Fig. 2 shows current-voltage (I-V) characteristics of the prepared carbonaceous thin film/n-type silicon multilayer cell sample. Without light irradiation, this sample exhibits rectifying I-V characteristics. When irradiating a light (Xe arc lamp) having a wavelength 400 to 850 nm and a power of 15 mW/cm$^2$ onto it, the sample generated short-circuit current $I_{sc}$ of about 2.73 mA/cm$^2$ and open-circuit voltage $V_{oc}$ of 325 mV. The fill factor value ff as derived from the I-V curve is about 0.65 and the energy conversion efficiency $\eta$ is about 3.8%.

Fig. 3 shows I-V characteristics of the sample without light irradiation, as measured at room temperature, in the form of a semi-logarithmic graph. The current-voltage relationship of the linear portion gives an ideality factor n and a dark current $I_o$, as determined by the following formula, of 1.10 and 1.5 x $10^{-5}$ mA/cm$^2$, respectively:

[FORMULA 1]

$$I = I_o \exp\left(\frac{qV}{nkT} - 1\right) \qquad (1)$$

Fig. 4 illustrates dependence on light wavelength (also known as spectroscopic characteristic) of short-circuit current and open-circuit voltage of this sample. This sample generates an almost constant photocurrent within a wavelength range of from 500 to 950 nm. This suggests the possibility of highly efficiently utilizing solar energy by the carbonaceous thin film/n-type silicon multilayer cell, and permits confirmation that this cell constitutes a solar cell or the like as an element known as a photoelectric transducer.

Example 2

A p-type silicon monocrystalline wafer, with boron (B) as dopant, having a thickness of 0.5 mm, was used as the substrate. Prior to depositing a carbonaceous thin film, the substrate was washed with fluoric acid in a concentration of 20%. The raw material for CVD reaction was $\alpha$, $\alpha$'-dichloro-p-xylene. The CVD reaction was caused under the atmospheric pressure under the following conditions:

| | |
|---|---|
| Substrate temperature: | 800°C |
| Material vaporizing temperature: | 100°C |
| Carrier gas: | argon |
| Depositing time: | 120 minutes |

The resultant carbonaceous thin film had a thickness of about 500 Å. In the resultant multilayer sample of carbonaceous thin film/p-type monocrystalline silicon, alloy electrodes were attached to the back of the substrate by ultrasonic welding. In addition, gold was vacuum-deposited into a thickness of 80 to 100 Å on the surface of the carbonaceous thin film as a sufrace electrode.

When light was not irradiated, this sample showed rectifying I-V characteristics. When irradiating light (Xe arc lamp) of a wavelength of 400 to 850 nm and a power of 40 mW/cm$^2$, the sample generated short-circuit current $I_{sc}$ of about 0.26 mA/cm$^2$ and open-circuit voltage $V_{oc}$ of 68 mV.

Example 3

An X-ray diffraction and a Raman analysis as applied to the 2,5-dimethyl-p-benzoquinone carbonaceous thin film deposited at 500°C in Example 1 demonstrated that the film had an amorphous-carbon structure. It has an electric conductivity of about 4.5 x $10^{-3}$ S/cm at the room temperature in the face direction. The contents of C, H and O as determined by element analysis were 87.2%, 0.37% and 12.4%, respectively. In Fig. 5 showing an absorption spectrum of the carbonaceous thin film, the one deposited at 500°C shows no intrinsic absorption peak, thus suggesting that this is an amorphous structure. The optical band gap $E_{opt}$ and the absorption coefficient $\alpha$ of an amorphous semiconductor have the following relationship:

[FORMULA 2]

$$\sqrt{\alpha \cdot h\nu} \propto (h\nu - E_{opt}) \qquad (2)$$

where, h is Planck's constant, $\nu$ is light frequency, and $h\nu$ indicates light energy. The optical band gap $E_{opt}$ of the 500°C carbonaceous thin film as determined by this Formula (2) is about 0.25 eV.

The 500°C carbonaceous thin film has a band gap of 0.25 eV, as described above. The junction type of the carbonaceous thin film/silicon multilayer sample is considered to be heterojunction. A typical junction band structure of the 500°C carbonaceous thin film/n-type silicon multilayer sample is shown in Fig. 6.

Fig. 7 shows the optical band gap Eopt of carbonaceous thin film. The carbonaceous thin film heat-treated at a temperature of up to 580°C shows a positive optical band gap Eopt, the optical band gap Eopt changes into a negative one at a temparature of over 580°C.

For this reason, the junction type of the carbonaceous thin film/semiconductor multilayer sample made at a temperature of up to 580°C is considered to be heterojunction type, and one made at a temperature of over 580°C is considered to be Schottky-barrier type.

According to the present invention, as described above in detail, a heterojunction type or Schottky-barrier type semiconductor element comprising a chemical vapor-deposited (CVD) carbonaceous thin film and an n-type or p-type semiconductor substrate was successfully prepared. As a result, the possibility was found to achieve quite a novel solar cell.

It should be noted that the objects and advantages of the invention may be attained by means of any compatible combination(s) particularly pointed out in the items of the following summary of the invention and the appended claims.

**SUMMARY OF INVENTION**

1. A heterojunction type semiconductor element wherein a carbonaceous thin film is chemically vapor-deposited on an n-type or p-type semiconductor substrate.

2. A Schottky-barrier type semiconductor element wherein a carbonaceous thin film is chemicaly vapor-deposited on an n-type or p-type semiconductor substrate.

3. A heterojunction type or Schottky-barrier type semiconductor element wherein said semiconductor substrate is a sheet-type or thinfilm-type monocrystalline silicon, polycrystalline silicon, amorphous silicon, a compound semiconductor or an n-type or p-type semiconductor corresponding thereto.

4. A heterojunction type or Schottky-barrier type semiconductor element wherein said carbonaceous thin film comprises a thin film chemically vapor-deposited from at least a kind of carbonaceous organic compound.

5. A heterojunction type or Schottky-barrier type semiconductor element wherein said carbonaceous thin film has a carbon content of at least 80%.

6. A heterojunction type or Schottky-barrier type semiconductor element wherein said carbonaceous thin film substantially has a non-diamond structure.

7. A heterojunction type or Schottky-barrier type semiconductor element wherein said carbonaceous thin film contains heteroatoms such as oxygen, nitrogen, boron phosphorus and halogen.

8. A heterojunction type or Schottky-barrier type semiconductor element wherein said carbonaceous thin film is chemically vapor-deposited.

9. A heterojunction type or Schottky-barrier type semiconductor element wherein said carbonaceous thin film is chemically vapor-deposited at a range of from room temperature to 1000°C.

10. A solar cell which comprises the heterojunction type or Schottky-barrier type semiconductor element.

## Claims

**1.** A heterojunction type semiconductor element wherein a carbonaceous thin film is chemically vapor-deposited on an n-type or p-type semiconductor substrate.

**2.** A Schottky-barrier type semiconductor element wherein a carbonaceous thin film is chemicaly vapor-deposited on an n-type or p-type semiconductor substrate.

**3.** A heterojunction type or Schottky-barrier type semiconductor element as claimed in claim or 1 or 2, wherein said semiconductor substrate is a sheet-type or thinfilm-type monocrystalline silicon, polycrystalline silicon, amorphous silicon, a compound semiconductor or an n-type or p-type semiconductor corresponding thereto.

**4.** A heterojunction type or Schottky-barrier type semiconductor element as claimed in any one of claims 1 to 3, wherein said carbonaceous thin film comprises a thin film chemically vapor-deposited from at least a kind of carbonaceous organic compound.

**5.** A heterojunction type or Schottky-barrier type semiconductor element as claimed in any one of claims 1 to 4, wherein said carbonaceous thin film has a carbon content of at least 80%.

**6.** A heterojunction type or Schottky-barrier type semiconductor element as claimed in any one of claims 1 to 5, wherein said carbonaceous thin film substantially has a non-diamond structure.

**7.** A heterojunction type or Schottky-barrier type semiconductor element as claimed in any one of claims 1 to 6, wherein said carbonaceous thin film contains heteroatoms such as oxygen, nitrogen, boron phosphorus and halogen.

**8.** A heterojunction type or Schottky-barrier type semiconductor element as claimed in any one of claims 1 to 7, wherein said carbonaceous thin film is chemically vapor-deposited and preferably at a range of from room temperature to 1000°C.

**9.** A solar cell which comprises the heterojunction type or Schottky-barrier type semiconductor element as claimed in any one of claims 1 to 9.

**10.** A semiconductor element wherein a carbonaceous thin film is deposited on a semiconductor substrate.

FIG. 1

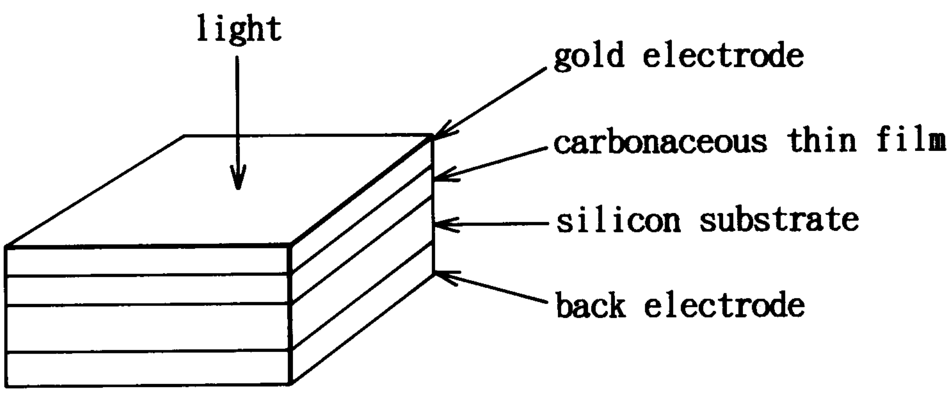
light
gold electrode
carbonaceous thin film
silicon substrate
back electrode

FIG. 2

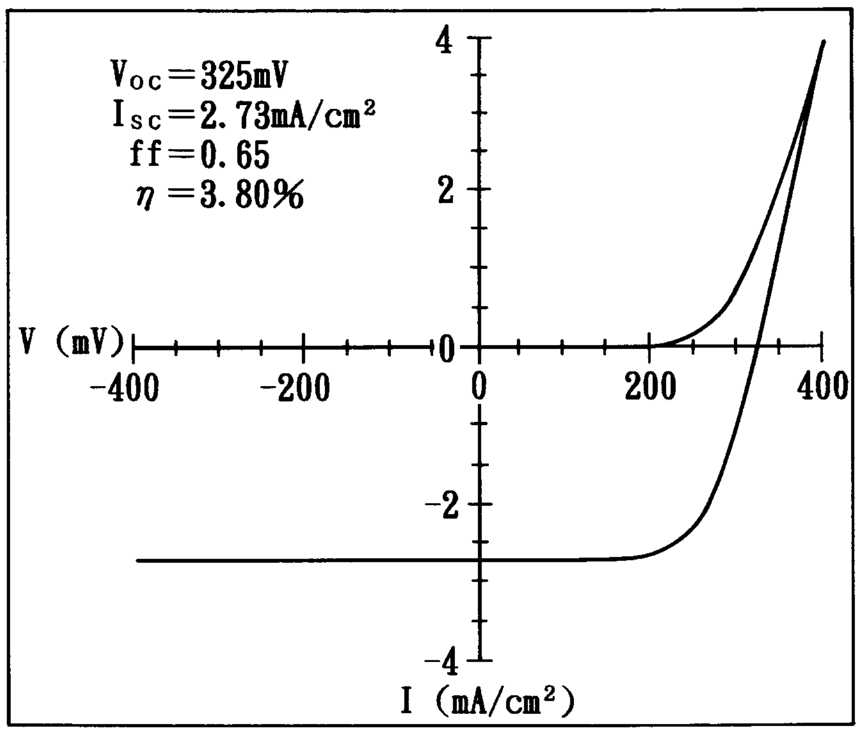


intensity of light : 15mW/cm²
wavelength : 400~850nm

*FIG. 3*

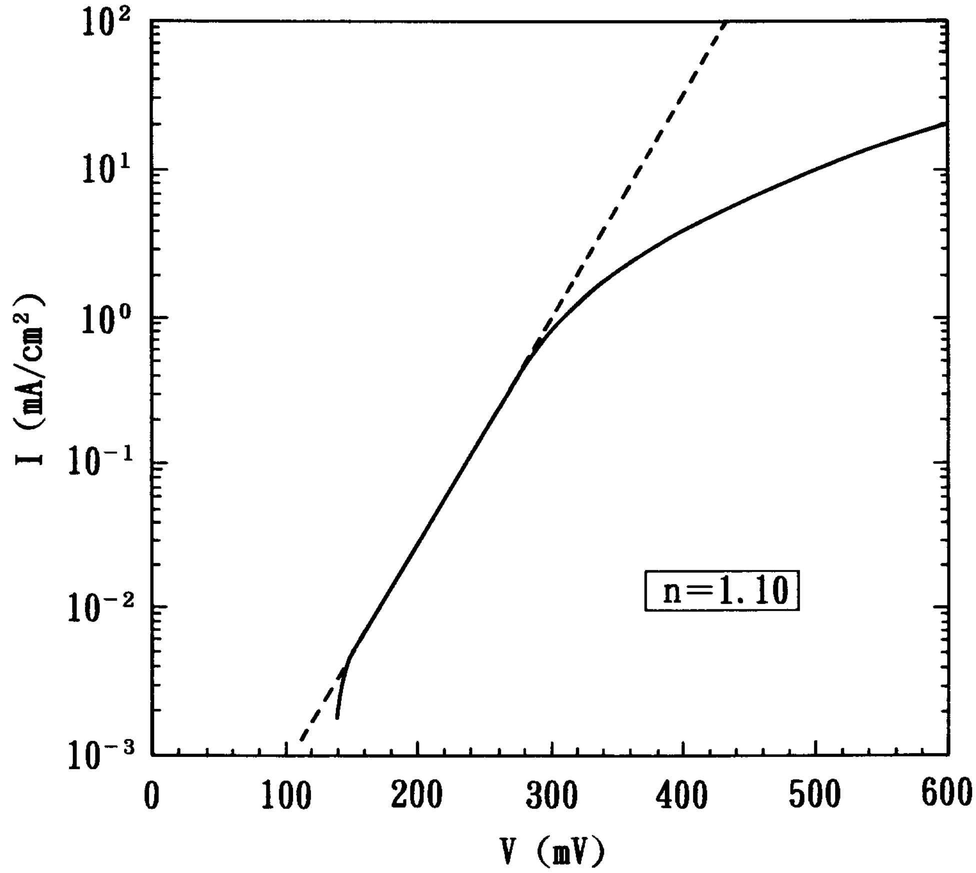
$10^2$
$10^1$
$10^0$
$10^{-1}$
$10^{-2}$
$10^{-3}$
I (mA/cm²)
n=1.10
0
100
200
300
400
500
600
V (mV)

FIG. 4

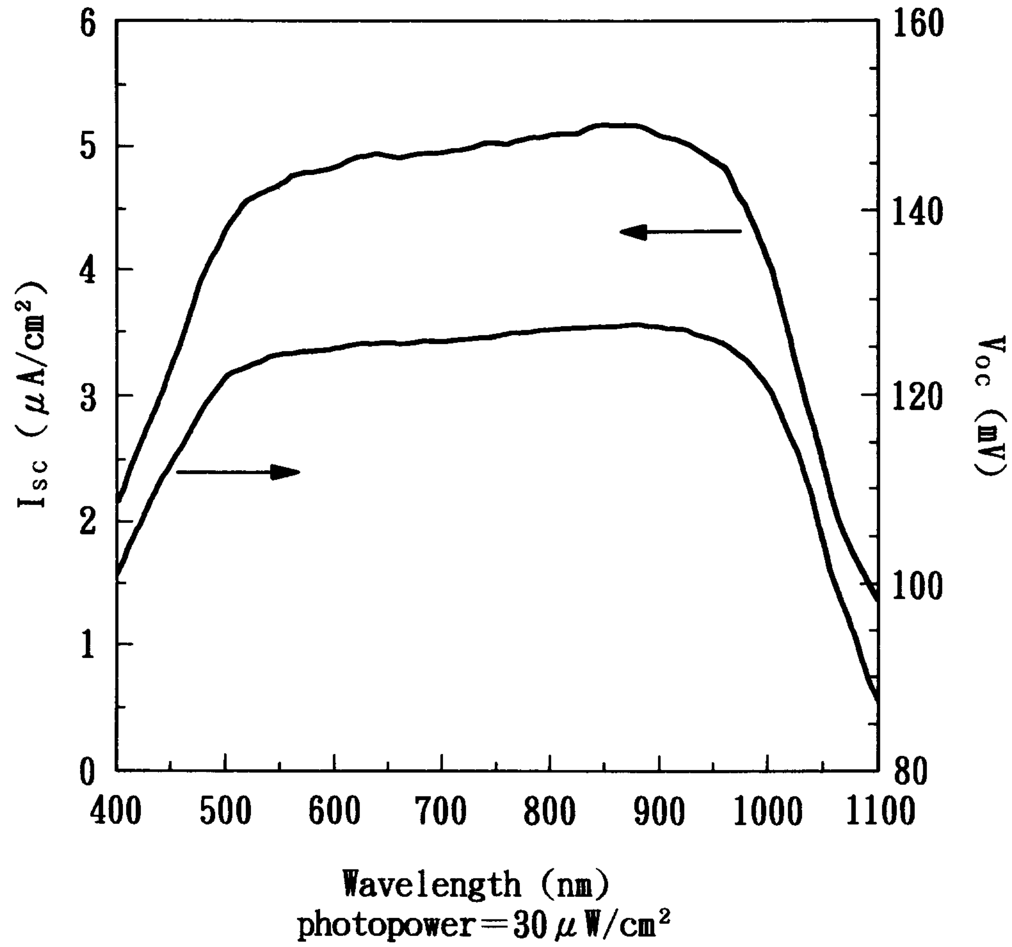

6
5
4
3
2
1
0
160
140
120
100
80
400
500
600
700
800
900
1000
1100
$I_{sc}$ ($\mu$A/cm²)
$V_{oc}$ (mV)
Wavelength (nm)
photopower=30$\mu$W/cm²

FIG. 5

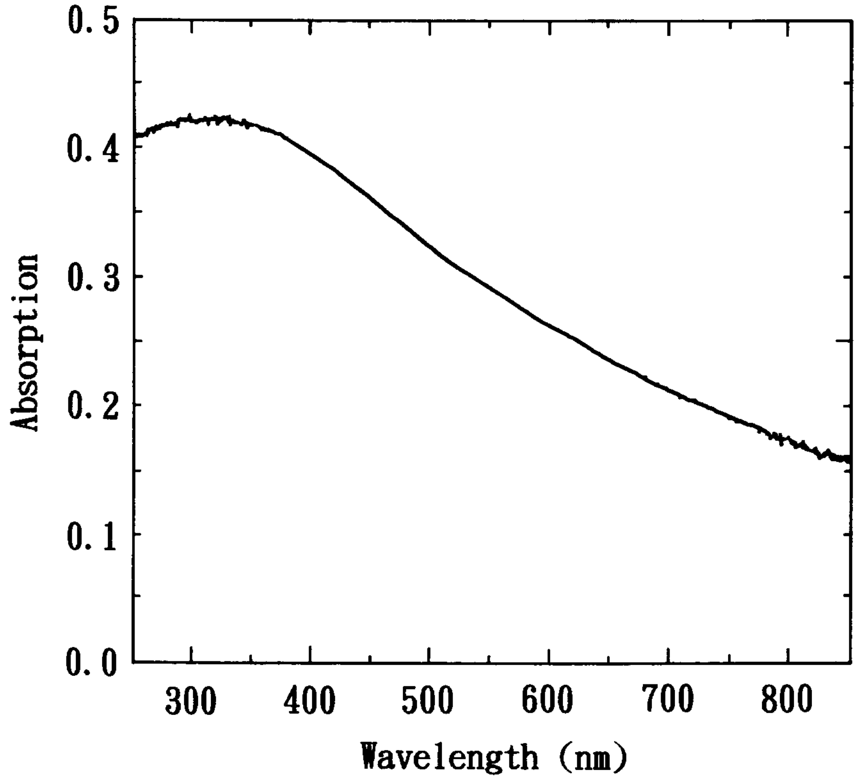
0.5
0.4
0.3
0.2
0.1
0.0
Absorption
300
400
500
600
700
800
Wavelength (nm)

FIG. 6

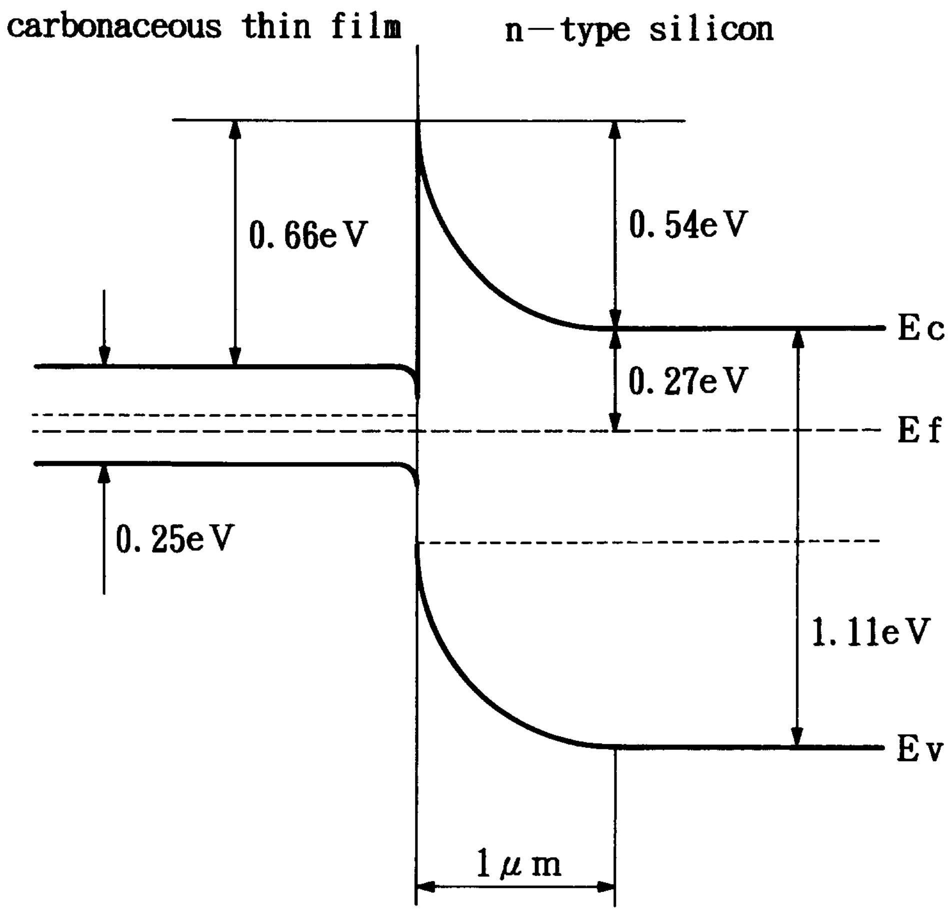
carbonaceous thin film
n−type silicon
0.66eV
0.54eV
Ec
0.27eV
Ef
0.25eV
1.11eV
Ev
1μm

FIG. 7

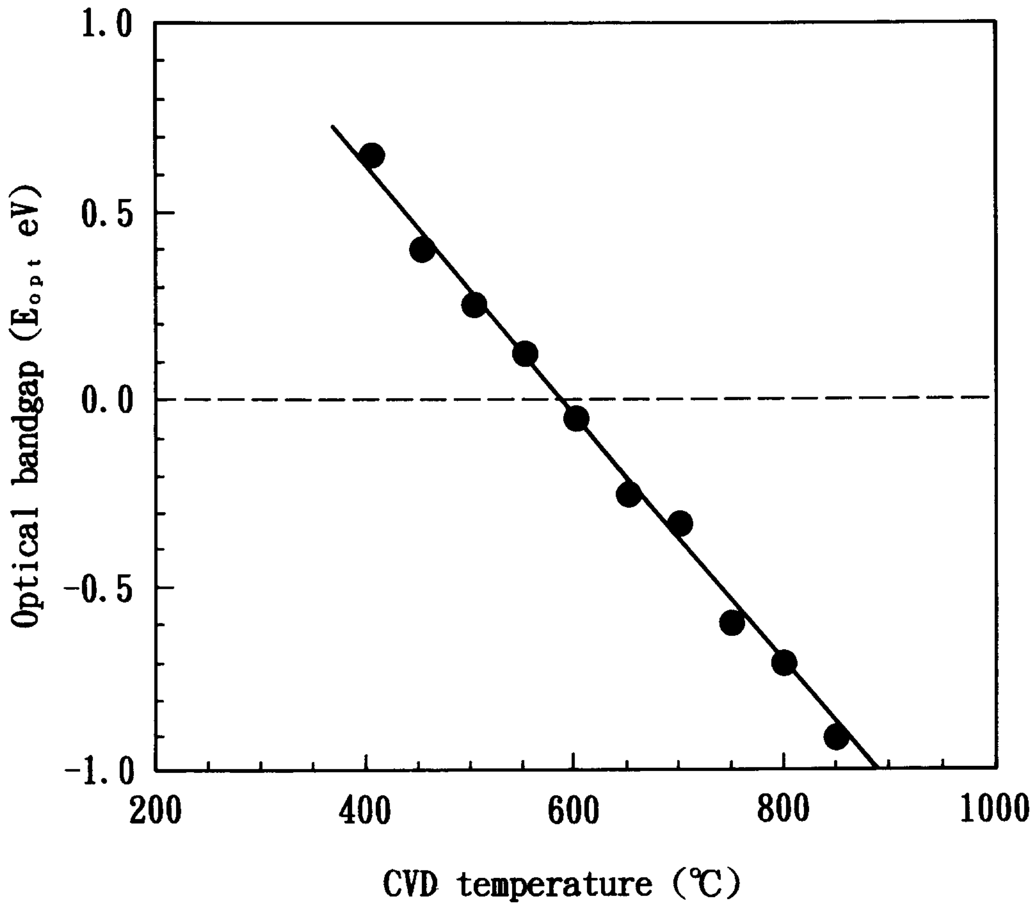
1.0
0.5
0.0
-0.5
-1.0
200
400
600
800
1000
Optical bandgap ($E_{opt}$ eV)
CVD temperature (℃)

European Patent Office

# EUROPEAN SEARCH REPORT

Application Number
EP 95 11 7698

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP-A-0 472 054 (SIEMENS AG) 26 February 1992<br>* the whole document *<br>--- | 1-6,8-10 | H01L29/165<br>H01L31/0376 |
| X | THIN SOLID FILMS,<br>vol. 212, no. 1 / 2, 15 May 1992<br>pages 232-239, XP 000360220<br>CHAN K K ET AL 'ELECTRONIC PROPERTIES OF SEMICONDUCTING DIAMOND-LIKE CARBON-DIAMOND'<br>* page 232, paragraph 1 - page 233, paragraph 2 *<br>--- | 1,3,5,8,10 | |
| X | APPLIED PHYSICS LETTERS,<br>vol. 61, no. 23, 7 December 1992<br>pages 2805-2807, XP 000335074<br>KONOFAOS N ET AL 'AMORPHOUS DIAMONDLIKE CARBON-SILICON HETEROJUNCTION DEVICES FORMED BY ION IMPLANTATION'<br>* the whole document *<br>--- | 1,3-8,10 | |
| | | | TECHNICAL FIELDS SEARCHED (Int.Cl.6) |
| X | ELECTRONICS LETTERS,<br>vol. 27, no. 22, 24 October 1991<br>pages 2043-2045, XP 000253714<br>HWANG S B ET AL 'AMORPHOUS CARBON/CRYSTALLINE SILICON HIGH VOLTAGE HETEROJUNCTION DIODE PREPARED BY PHOTOCHEMICAL VAPOUR DEPOSITION'<br>* the whole document *<br>--- | 1,3,5,8,10 | H01L |
| X | APPLIED PHYSICS LETTERS,<br>vol. 53, no. 7, 15 August 1988<br>pages 586-588, XP 000118691<br>GILDENBLAT G S ET AL 'ELECTRICAL CHARACTERISTICS OF SCHOTTKY DIODES FABRICATED USING PLASMA ASSISTED CHEMICAL VAPOR DEPOSITED DIAMOND FILMS'<br>* the whole document *<br>---<br>-/-- | 2,3,7,8,10 | |

The present search report has been drawn up for all claims

| Place of search | Date of completion of the search | Examiner |
|---|---|---|
| THE HAGUE | 20 February 1996 | De Laere, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent Office

# EUROPEAN SEARCH REPORT

Application Number
EP 95 11 7698

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | THIN SOLID FILMS, vol. 64, no. 1, N SOLID FILMS, 15 NOV. 1979, SWITZERLAND, pages 57-62, BHAGAVAT G K ET AL 'Semiconducting amorphous carbon films and carbon-single-crystal silicon heterojunctions' * the whole document * | 10 | |
| A | | 1,3,5,6, 9 | |
| | ----- | | |

TECHNICAL FIELDS SEARCHED (Int.Cl.6)

The present search report has been drawn up for all claims

| Place of search | Date of completion of the search | Examiner |
|---|---|---|
| THE HAGUE | 20 February 1996 | De Laere, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)